# EUROPÄISCHE PATENTANMELDUNG

(11) **EP 1 232 996 A2**
(43) Veröffentlichungstag der Anmeldung: **21.08.2002**
(21) Anmeldenummer: 01127972.6
(22) Anmeldetag: 24.11.2001
(51) Int. Cl.: B81B 3/00

(54) **Mikromechanisches Bauelement und Verfahren zu seiner Herstellung**

(30) Priorität: 14.02.2001 DE 10106715
(71) Anmelder: ROBERT BOSCH GMBH, 70442 Stuttgart (DE)
(72) Erfinder: Fischer, Frank, 72810 Gomaringen (DE); Frey, Wilhelm, Dr., Palo Alto, C-94304 (US)

(57) **Zusammenfassung**

Bei der Herstellung eines mikromechanischen Bauelements mit gegeneinander beweglichen Komponenten (7, 8) aus einem Substrat wird eine leitfähige Beschichtung (10) wenigstens auf einander zugewandten Oberflächen (9) der gegeneinander beweglichen Komponenten (7, 8) aufgebracht.

## Beschreibung

### STAND DER TECHNIK

### Die vorliegende Erfindung betrifft ein mikromechanisches Bauelement und ein Verfahren zu seiner Herstellung.

Die Funktion herkömmlicher mikromechanischer Bauelemente kann durch Adhäsionskräfte beeinträchtigt werden, die unter ungünstigen Umständen zwischen einander zugewandten Oberflächen von beweglichen Komponenten der Bauelemente wirksam sind. Diese Adhäsionsneigung, in der Literatur auch als "Stiction" bekannt, wird im allgemeinen zurückgeführt auf die Ausbildung von van der Waals- und Kapillarkräften, elektrostatische Wechselwirkung, Körper- und Wasserstoffbrückenbindungen zwischen den einander zugewandten Oberflächen.

Derartige Adhäsionserscheinungen können die Funktionsfähigkeit von mikromechanischen Bauelementen wie insbesondere von Sensoren wie etwa Beschleunigungs- oder Drehratensensoren empfindlich beeinträchtigen. Grundlegendes Element solcher Sensoren ist meist eine seismische Masse, die gegen einen umgebenden Rahmen unter dem Einfluss der zu erfassenden Beschleunigung oder Drehung bewegbar ist, und deren Bewegung erfasst wird durch Nachweis der Kapazitätsänderung von Kondensatoren, deren Platten jeweils durch einander zugewandte Oberflächen der seismischen Masse und des Rahmens gebildet sind. Jede Adhäsionskraft, die zwischen solchen einander zugewandten Oberflächen wirkt und eine Verlagerung der seismischen Masse zur Folge hat, bewirkt eine empfindliche Verfälschung der Messergebnisse des Sensors.

Um Festkörperadhäsion zu reduzieren, werden Verfahren vorgeschlagen, bei denen diese Oberflächen durch Maskierungsschichten wie z.B. durch selbstordnende Monolagen chemisch stabilisiert werden, bei denen die Oberflächen durch Beschichtung, etwa mit diamantartigen Kohlenstoffschichten, gehärtet werden, oder die Oberflächentopographie, d.h. die Gestalt der Kontaktflächen und insbesondere ihre Oberflächenrauhigkeit, optimiert wird. Diese Verfahren sind meist aufwendig, da die einander zugewandten Oberflächen für eine nachträgliche Bearbeitung schlecht zugänglich sind. Auch führen sie nicht immer zum gewünschten Erfolg.

### VORTEILE DER ERFINDUNG

Durch die vorliegende Erfindung werden ein mikromechanisches Bauelement und ein einfaches und preiswertes Verfahren zu dessen Herstellung geschaffen, bei dem Adhäsionserscheinungen wirksam reduziert sind.

Die Erfindung geht auf die Erkenntnis zurück, dass Meßwertverfälschungen bei mikromechanischen Sensoren häufig im Laufe des Betriebs der Sensoren allmählich veränderlich sind, was von den Erfindern auf die allmähliche Ausbildung von elektrostatischen Ladungen auf nichtleitenden Oberflächen der Sensoren zurückgeführt wird. Um diese elektrostatischen Ladungen zu bekämpfen, wird vorgeschlagen, zumindest diejenigen Oberflächen eines mikromechanischen Bauelements, die einander gegenüberliegen, mit einer leitfähigen Beschichtung zu versehen, die ein Abfließen der elektrostatischen Ladungen ermöglicht.

Die Leitfähigkeit einer solchen Beschichtung kann um mehrere Zehnerpotenzen kleiner sein als die eines typischen elektrischen Leiters des mikromechanischen Bauelements, wie etwa der Zuleitung einer Kondensatorelektrode. Eine solche geringe Leitfähigkeit ist ausreichend, um die mit elektrostatischer Aufladung verbundenen minimalen Stromstärken abzuführen, beeinträchtigt aber nicht merklich die Funktionsweise des Bauelements.

Um eine Beschichtung mit einer nichtverschwindenden aber dennoch sehr geringen Leitfähigkeit kontrolliert aufbringen zu können, ist es vorteilhaft, die Beschichtung aus einem Material zu bilden, das eine nicht verschwindende Leitfähigkeit aufweist und das kein hochisoloerendes Oxid an seiner Oberfläche bildet. Ein solches Material ist Germanium. Es kann in reiner Form oder bei Bedarf auch mit einer Dotierung zur Steuerung seiner Leitfähigkeit aufgebracht werden.

Wenn das Substrat des mikromechanischen Bauelements aus Silizium besteht, so hat die Verwendung einer Beschichtung aus Germanium darüber hinaus den Vorteil, dass sie leicht zu strukturieren ist, da Germanium zwar auf einer Silizium Oberfläche nukleiert, nicht aber auf einer Oberfläche aus Siliziumoxid.

Gegenstand der Erfindung ist auch ein Verfahren zur Herstellung eines gegeneinander bewegliche Komponenten aufweisenden mikromechanischen Bauelements aus einem Substrat, bei dem eine leitfähige Beschichtung wenigstens auf einander zugewandten Oberflächen der gegeneinander beweglichen Komponenten aufgebracht wird. Ein solches Substrat kann zweckmäßigerweise eine zu strukturierende Funktionsschicht und eine darunterliegende Opferschicht umfassen. Die gegeneinander beweglichen Komponenten können dann erzeugt werden durch Ätzen von Gräben durch die Funktionsschicht bis zur Opferschicht und Beseitigen der Opferschicht unter wenigstens einer der Komponenten.

Das Material der Beschichtung ist zweckmäßigerweise so gewählt, dass es sich auf der Funktionsschicht, nicht aber auf der Opferschicht ablagert. Wenn die Beschichtung nach dem Ätzen der Gräben, aber vor dem Beseitigen der Opferschicht aufgebracht wird, ermöglicht dies eine selektive Anbringung der Beschichtung insbesondere an den Seitenwänden der Gräben, die beim fertigen mikromechanischen Bauelement einander zugewandte Oberflächen der gegeneinander beweglichen Komponenten bilden werden, ohne dass hierfür ein eigener Maskenschritt erforderlich ist.

Diese Anforderungen erfüllt insbesondere Germanium, wenn die Funktionsschicht aus Silizium und die Opferschicht aus Siliziumoxid besteht.

Bevor die Funktionsschicht durch Erzeugen der Gräben darin strukturiert wird, wird herkömmlicherweise eine Maskierungsschicht auf einem Teil der Funktionsschicht erzeugt, und die Gräben werden durch Ätzen des nicht von der Maskierungsschicht bedeckten Teils der Funktionsschicht gebildet. Wenn die Maskierungsschicht erst nach dem Aufbringen der leitfähigen Beschichtung entfernt wird, kann, je nach Art der Maskierungsschicht, vermieden werden, dass Beschichtungsmaterial sich auf der Maskierungsschicht niederschlägt oder niedergeschlagenes Beschichtungsmaterial wird gemeinsam mit der Maskierungsschicht entfernt. Auf diese Weise kann eine ursprünglich mit der Maskierungsschicht bedeckte Außenseite des Substrats beim fertigen Bauelement frei von der leitfähigen Beschichtung gehalten werden.

Es kann jedoch auch die Maskierungsschicht vor dem Aufbringen der leitfähigen Beschichtung entfernt werden, wenn eine solche Beschichtung an der Außenseite erwünscht ist oder in Kauf genommen werden kann.

Zum Abscheiden der Beschichtung wird bevorzugt ein LPCVD-Verfahren (Niederdruck-Dampfabscheidungsverfahren) eingesetzt, da es bei niedrigen Temperaturen durchgeführt werden kann, bei denen eine bereits zuvor hergestellte Struktur des Bauelements nicht beeinträchtigt wird.

### ZEICHNUNGEN

Ausführungsbeispiele der Erfindung sind in den Zeichnungen dargestellt und in der nachfolgenden Beschreibung näher erläutert.

Es zeigen:
- Fig. 1 bis 4: Schritte einer ersten Ausgestaltung eines Verfahrens zum Herstellen eines mikromechanischen Bauelements; und
- Fig. 5 und 6: Schritte einer zweiten Ausgestaltung eines Verfahrens.

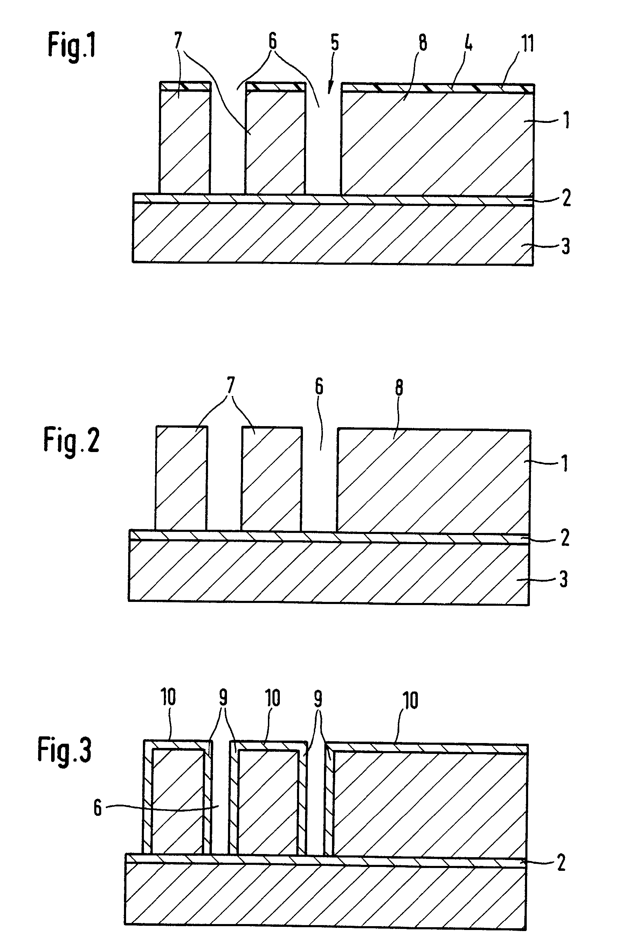

Fig. 1 zeigt einen Querschnitt durch ein Substrat, aus dem ein mikromechanisches Bauelement hergestellt werden soll. Das Substrat ist hergestellt durch Abscheiden einer Funktionsschicht 1 aus polykristallinem Silizium auf einer von einer SiO₂-Opferschicht 2 bedeckten Unterlage 3 aus Silizium. Auf der Funktionsschicht 1 wurde eine Fotolack-Schicht 4 aufgetragen, und in durch Belichten und Entwickeln der Fotolack-Schicht 4 gebildeten Fenstern 5 wurden Gräben 6 durch die Funktionsschicht 1 bis hin zur Opferschicht 2 geätzt. Die Verfahren zum Erzeugen der Schichtstruktur des Substrats und zum Strukturieren der Funktionsschicht 1 sind herkömmlich und werden deshalb hier nicht genauer beschrieben.

Die Gräben 6 trennen hier zwei schmale Stege 7 der Funktionsschicht 1 voneinander und von einem massiven Abschnitt 8. Die Stege 7 sind z.B. vorgesehen, um am fertigen mikromechanischen Bauelement langgestreckte, parallele Elektrodenfinger zu bilden, von denen z.B. einer an einer Schmalseite mit einer seismischen Masse (nicht dargestellt) und der andere mit dem massiven Abschnitt 8 verbunden ist, der auch beim fertigen Bauelement mit der Unterlage 3 fest verbunden bleibt.

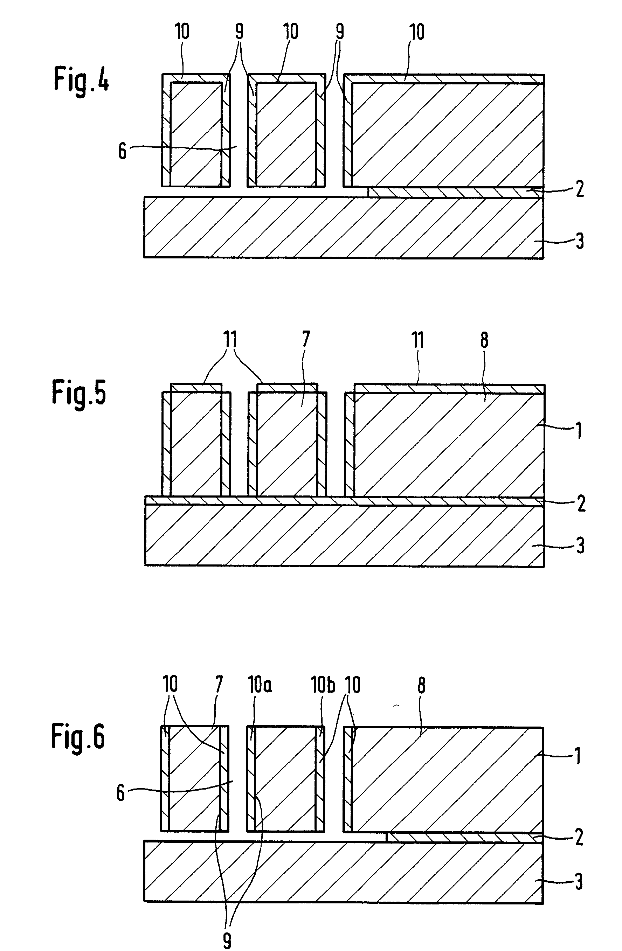

In Fig. 2 ist die Fotolack-Schicht 4 an der Außenfläche des Substrats beseitigt. Damit ist das Substrat bereit, um eine LPCVD-Behandlung mit GeH₄ vorzunehmen, nach der wie in Fig. 3 gezeigt, alle freiliegenden Oberflächen der Funktionsschicht 1, d.h. sowohl die Außenfläche als auch einander zugewandte Oberflächen 9 der Stege 7 bzw. des massiven Abschnitts 8, mit einer dünnen Beschichtung 10 aus Germanium überzogen sind. Die am Boden der Gräben 6 freiliegende Opferschicht 2 bleibt unbedeckt, da das Germanium sich auf SiO₂ nicht niederschlägt. Anschließend wird durch die Gräben 6 hindurch die Opferschicht 2 so lange geätzt, bis die Stege 7 an ihrer Unterseite frei und unverbunden sind, wie in Fig. 4 gezeigt.

Wenn, wie bei diesem Beispiel angenommen, eine Fotolack-Schicht 4 zur Maskierung der nicht zu ätzenden Bereiche der Funktionsschicht 1 dient, so wird diese Schicht zweckmäßigerweise vor der LPCVD-Behandlung beseitigt, da die aktuell gebräuchlichen Fotolacke bei den üblichen Temperaturen eines LPCVD-Abscheidungsprozesses von 350°C bis 500°C nicht stabil sind.

Einer zweiten Ausgestaltung des Verfahrens zufolge kann die Außenseite des Substrats aber auch mit einer Oxidschicht, d.h. hier einer SiO₂-Schicht 11, als Maskierungsschicht überzogen sein, und das Ätzen der Gräben 6 findet in Fenstern dieser SiO₂-Schicht statt. Der Querschnitt einer solchen Struktur ist der gleiche wie in Fig. 1 gezeigt.

Da jedoch die SiO₂-Schicht 11 bei hohen Temperaturen beständig ist, kann hier die Germanium-Beschichtung 10 in einem LPCVD-Prozess aufgebracht werden, ohne dass zuvor die passivierende SiO₂-Schicht 11 an der Außenseite des Substrats beseitigt wird. Das Ergebnis ist in Fig. 5 gezeigt. Die Germanium-Beschichtung 10 erstreckt sich hier nur über die zugewandten Oberflächen 9 der Stege 7 bzw. des massiven Abschnitts 8, die die Seitenwände der Gräben 6 bilden.

Wenn anschließend die Opferschicht 2 unter den Stegen 7 weggeätzt wird, so führt dies gleichzeitig zur Abtragung der SiO₂-Schicht 11 an der Außenseite des Substrats. Das Ergebnis ist in Fig. 6 gezeigt. Da keine leitfähige Beschichtung 10 an der Außenfläche des Substrats vorhanden ist, können hier Beschichtungsabschnitte wie 10a, 10b an abgewandten Oberflächen eines gleichen Stegs 7 voneinander elektrisch isoliert sein, sofern nicht die Gräben 6, die den Steg 7 umgeben, miteinander verbunden sind.

## Patentansprüche

1. Verfahren zur Herstellung eines gegeneinander bewegliche Komponenten (7, 8) aufweisenden mikromechanischen Bauelements aus einem Substrat, **gekennzeichnet durch** den Schritt des Aufbringens einer leitfähigen Beschichtung (10) wenigstens auf einander zugewandten Oberflächen (9) der gegeneinander beweglichen Komponenten (7, 8).

2. Verfahren nach Anspruch 1, **dadurch gekennzeichnet, dass** das Substrat eine zu strukturierende Funktionsschicht (1) und eine darunter liegende Opferschicht (2) umfasst, und dass die gegeneinander beweglichen Komponenten (7, 8) erzeugt werden durch Ätzen von Gräben (6) durch die Funktionsschicht (1) bis zur Opferschicht (2) und Beseitigen der Opferschicht (2) unter wenigstens einer der Komponenten (7).

3. Verfahren nach Anspruch 1 oder 2, **dadurch gekennzeichnet, dass** das Substrat aus Silizium und die leitfähige Beschichtung (10) aus Germanium besteht.

4. Verfahren nach Anspruch 2 und Anspruch 3, **dadurch gekennzeichnet, dass** die Beschichtung (10) nach dem Ätzen der Gräben (6) und vor dem Beseitigen der Opferschicht (2) aufgebracht wird.

5. Verfahren nach einem der vorhergehenden Ansprüche, **dadurch gekennzeichnet, dass** die Opferschicht (2) aus SiO₂ besteht.

6. Verfahren nach einem der vorhergehenden Ansprüche, **dadurch gekennzeichnet, dass** zum Strukturieren der Funktionsschicht (1) eine Maskierungsschicht (11) auf einem Teil der Funktionsschicht (1) erzeugt wird und die Gräben (6) durch Ätzen des nicht von der Maskierungsschicht (11) bedeckten Teils der Funktionsschicht (1) gebildet werden, und dass die Maskierungsschicht (11) nach dem Aufbringen der leitfähigen Beschichtung (10) entfernt wird.

7. Verfahren nach einem der Ansprüche 1 bis 5, **dadurch gekennzeichnet, dass** zum Strukturieren der Funktionsschicht (1) eine Maskierungsschicht (4) auf einem Teil der Funktionsschicht (1) erzeugt wird und die Gräben (6) durch Ätzen des nicht von der Maskierungsschicht (4) bedeckten Teils der Funktionsschicht (1) gebildet werden, und dass die Maskierungsschicht (4) vor dem Aufbringen der leitfähigen Beschichtung (10) entfernt wird.

8. Verfahren nach Anspruch 6 oder 7, **dadurch gekennzeichnet, dass** die Maskierungsschicht (4, 11) eine Oxidschicht (11) oder Lackschicht (4) ist.

9. Verfahren nach einem der vorhergehenden Ansprüche, **dadurch gekennzeichnet, dass** die Beschichtung (10) in einem LPCVD-Prozess abgeschieden wird.

10. Mikromechanisches Bauelement mit einem Substrat, in dem gegeneinander bewegliche Komponenten (7, 8) ausgebildet sind, **dadurch gekennzeichnet, dass** wenigstens einander zugewandte Oberflächen (9) der Komponenten (7, 8) eine leitfähige Beschichtung (10) tragen.

11. Bauelement nach Anspruch 10, **dadurch gekennzeichnet, dass** das Substrat aus Silizium und die Beschichtung (10) aus Germanium besteht.

12. Bauelement nach Anspruch 10 oder 11, **dadurch gekennzeichnet, dass** das Substrat eine Außenseite aufweist, die im wesentlichen frei von der leitfähigen Beschichtung (10) ist.
